# EUROPEAN PATENT SPECIFICATION

(11) **EP 1 622 431 B1**
(45) Date of publication and mention of the grant of the patent: **17.09.2008**
(21) Application number: 04018155.4
(22) Date of filing: 30.07.2004
(51) Int. Cl.: H05K 1/02, H05K 3/46

(54) **Circuit board with identifiable information and method for fabricating the same**
Leiterplatte mit identifizierbaren Informationen und Herstellungsverfahren
Circuit imprimé avec information identifiable et procédé de fabrication

(43) Date of publication of application: 01.02.2006
(73) Proprietor: Phoenix Precision Technology Corporation, Hsin-Chu (TW)
(72) Inventor: Hsu, Shih-Ping, Hsin-chu (TW); Chen, Shang-Wei, Hsin-chu (TW); Tang, Suo-Hsia, Hsin-chu (TW); Shih, Chao-Wen, Hsin-chu (TW)
(74) Representative: Manitz, Finsterwald & Partner GbR

(56) References cited:
- US-A- 4 642 160
- US-A- 4 652 734
- US-A1- 2002 117 468
- US-A1- 2003 001 256
- PATENT ABSTRACTS OF JAPAN vol. 2000, no. 15, 6 April 2001 (2001-04-06) -& JP 2000 340950 A (MATSUSHITA ELECTRIC IND CO LTD), 8 December 2000 (2000-12-08)

## Description

### FIELD OF THE INVENTION

The present invention relates to circuit boards with identifiable information marks and methods for fabricating the same.

### BACKGROUND OF THE INVENTION

With the development of the electronic industry, electronic products tend to be made small in size and with high performance, functionality and operating speed. In order to fabricate highly integrated and miniaturized semiconductor devices, a circuit board for carrying a plurality of active elements and circuits is gradually evolved from a double-layer board to a multi-layer board on which available circuit area is increased using the interlayer connection technology to accommodate a high density of integrated circuits in a limited space.

Conventional fabrication processes of a circuit board include performing a series of tests of electrical performance and mechanical strength on the circuit board after the circuit board is formed with circuits, and then providing a serial number or other relevant fabrication information on the circuit board for subsequent product tracing.

However, the above serial number or relevant fabrication information is formed by printing or laser as a pattern or mark on a surface of a solder mask layer of the circuit board when the circuit board is fabricated. Formation of such a pattern or mark cannot be performed inside the circuit board, and also increases the fabrication time and cost. Further, it may happen that the pattern or mark on the surface of the circuit board cannot be recognized or traced when an encapsulating process is carried out to encapsulate the circuit board for forming a semiconductor device.

JP-A-2000340950 discloses a multi-layer circuit board comprising a via hole wherein a through hole is filled with a conductive paste. Inspection via holes as an inspection mark are formed on a substrate so as not to overlap each other in a lamination direction. The inspection via holes are arranged in a circle.

US-A-2002/ 117468 discloses a method for forming a recognition mark on the back surface of a substrate wherein a conductive pattern is formed as a recognition mark. The conductive pattern may have a shape as the recognition mark or a through hole may have this shape as the recognition mark.

US-A-4,652,734 discloses a method of feeding information into data processing means of an automatic galvanizing installation.

US-A-4,642,160 discloses a multi-layer circuit board.

US-A-2003/0001256 discloses a wiring board for a semiconductor package comprising a wiring layer consisting of necessary wiring patterns and individual patterns as position information.

### SUMMARY OF THE INVENTION

In light of the above drawbacks in the prior art, a primary objective of the present invention is to provide a circuit board with identifiable information marks and a method for fabricating the same, which can allow the circuit board to be identified and traced from fabricating processes to a status of being in use.

Another objective of the present invention is to provide a circuit board with identifiable information marks and a method for fabricating the same, which can provide reliable tracing of the circuit board and reduce the fabrication cost thereof.

In accordance with the above and other objectives, the present invention proposes a method for fabricating a circuit board according to claim 1.

The present invention also provides a circuit board according to claim 9.

The circuit board with identifiable information marks and the method for fabricating the same according to the present invention are to form a plurality of openings in a non-circuit area of the circuit board not having a circuit layout during fabrication of the circuit board. The openings may be shaped as letters or patterns, allowing a metal layer to be deposited in the openings during the fabrication of the circuit board. The letters or patterns formed by the metal layer in the openings are used as metal identifiable information marks for identifying and tracing the circuit board from the fabricating processes to a status of being in use, thereby providing a reliable product tracing mechanism.

Moreover, the metal identifiable information marks of the circuit board can be formed in any layer within a multi-layer circuit board so as not to occupy the outer circuit layout space. In such a case, when the circuit board is fabricated, the metal identifiable information is readable using an X-ray instrument instead of by eyes or a microscope. Alternatively, in the case of having sufficient outer circuit layout space on the circuit board, the metal identifiable information may be formed in same layer as the outer circuit layer and thus can be directly identified by eyes, a microscope or a bar code reader.

To provide a further understanding of the invention, the following detailed description illustrates embodiments and examples of the invention, it is to be understood that this detailed description is being provided only for illustration of the invention and not as limiting the scope of this invention.

### BRIEF DESCRIPTION OF THE DRAWINGS

The present invention can be more fully understood by reading the following detailed description of the preferred embodiments, with reference made to the accompanying drawings, wherein:
FIGs. 1A to 1F are schematic cross-sectional views showing the procedural steps of a method for fabricating a circuit board with identifiable information according to a preferred embodiment of the present invention; and
FIG. 2 is a schematic cross-sectional view of a circuit board with identifiable information according to another preferred embodiment of the present invention.

### DETAILED DESCRIPTION OF THE PREFERRED EMBODIMENTS

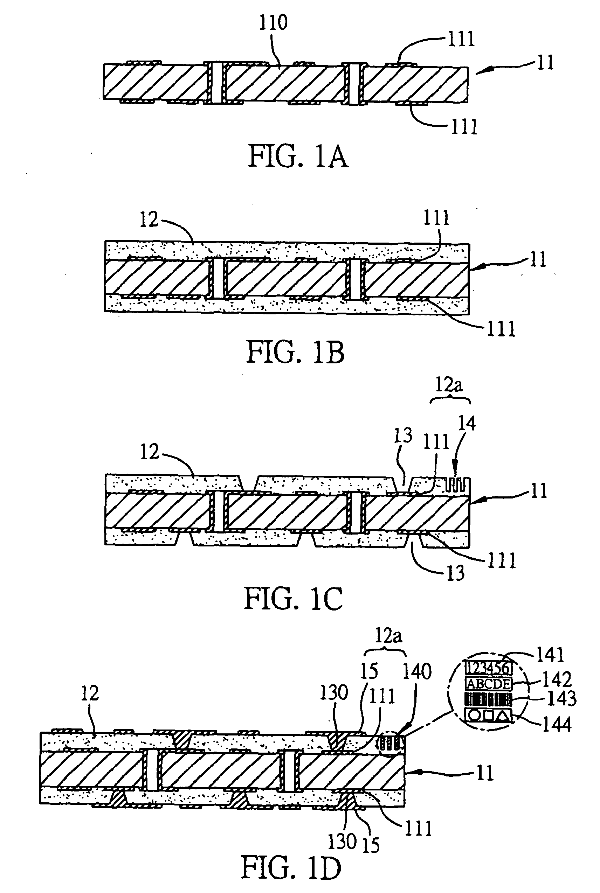

FIGs. 1A to 1F show the procedural steps of a method for fabricating a circuit board with identifiable information marks (hereafter called "identifiable information) according to a preferred embodiment of the present invention. It should be noted here that the drawings are made simple only showing the parts and components of the circuit board relevant to the present invention, and the actual number, shape, and size of the components in the practice should be more complicated.

Referring to FIG. 1A, a core board 11 is provided comprising an insulating layer 110 and a patterned circuit layer 111 formed on the insulating layer 110. The core board 11 may be a multi-layer circuit board that has undergone pre-treatment processes. Fabrication of the core board 11 employs conventional technology, which is thereby not to be further detailed herein.

Referring to FIG. 1B, another insulating layer 12 is formed on a surface of the core board 11 and covers the circuit layer 111. The insulating layer 12 can be made of a non-fiber resin material such as ABF (Ajinomoto Build up Film), or a fiber-resin pre-preg material such as BT (bismaleimide triazine) added with glass fiber or a mixture of epoxy resin and glass fiber (FR4 resin), etc.

Referring to FIG. 1C, a plurality of first openings 13 and second openings 14 are formed in the insulating layer 12 by for example laser drilling technology. The plurality of first openings 13 are disposed on a part of the circuit layer 111 covered by the insulating layer 12 and act as blind vias to expose the part of the circuit layer 111. The plurality of second openings 14 are located at a non-circuit area 12a of the insulating layer 12 not covering the circuit layer 111, preferably at a peripheral area of the circuit board, or at a non-peripheral area of the circuit board not affecting the circuit layout.

Referring to FIG. 1D, a build up process is performed to form a conductive circuit layer 15 on the insulating layer 12, a plurality of conductive vias 130 in the first openings 13 of the insulating layer 12 for electrically connecting the circuit layer 15 to the circuit layer 111 of the core board 11, and metal identifiable information 140 in the plurality of second openings 14 of the insulating layer 12. The metal identifiable information 140 may be numbers 141, letters 142, bar codes 143 or various patterns 144, etc. which relates to the serial number or fabrication information of the circuit board. In the brief description of the drawings, though it only disclose a semi-additive process of performing the build up process to form a conductive circuit layer 15 above the core board 11. It is to be understood that the method of the fabricating the conductive circuit layer 15 is not limited to the disclosed method. The conductive circuit layer forming method further comprise the subtractive process and pattern process. The subtractive process is to etch the foil (not shown) attached onto the insulating layer 12 to form the conductive circuit layer 15, and the pattern process is to perform an electroplating process to form a conductive circuit layer 15 over a thinner metal layer (not shown) on the insulating layer 12. Performing the build up process to form the conductive circuit layer 15 on the core board 11 could employ one of the selection methods of the subtractive process, pattern process and semi-additive process. Since fabrication of the conductive circuit layer employs conventional technology, it is not to be further detailed herein.

In the case of having sufficient outer circuit layout space on the circuit board, if the conductive circuit layer 15 is an outer circuit layer, the metal identifiable information 140 of the circuit board can be formed in the same layer as the outer circuit layer 15. As a result, the metal identifiable information 140 can be read during the fabrication processes of the circuit board by eyes, a microscope or a bar code reader, or through the use of a microprocessor, computer or programmable controller, so as to continuously trace a product status of the circuit board according to the original fabrication conditions.

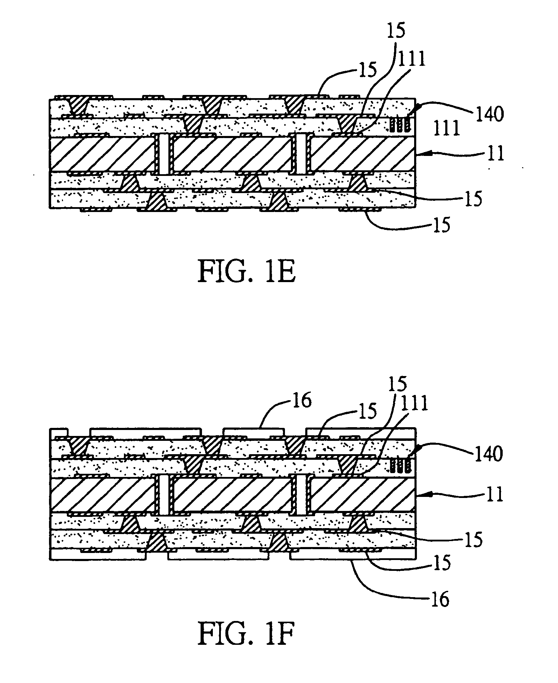

Referring to FIGs. 1E and 1F, the circuit board according to the present invention can be a multi-layer circuit board fabricated by continuing the build up process to form a plurality of conductive circuit layers 15 on the core board 11 (FIG. 1E). A patterned insulating protection layer 16 such as solder mask layer can be formed on the outer conductive circuit layer 15 (FIG. 1F) to protect circuit structures covered thereby. Thus, the metal identifiable information 140 is covered by the subsequently formed circuit layer 15 or the patterned insulating protection layer 16. However, the metal identifiable information 140 can still be identified by for example an X-ray instrument cooperative with a microprocessor, computer or programmable controller to continuously trace the product status of the circuit board. In other words, the metal identifiable information 140 may be formed in any layer within the circuit board so as not to occupy the outer circuit layout space. In this case, when the circuit board is fabricated, the metal identifiable information 140 is recognizable using the X-ray instrument instead of by eyes or the microscope.

By the method described above, the circuit board with identifiable information according to the present invention is fabricated. This circuit board comprises a core board 11 having a patterned circuit layer 111 formed on a surface thereof; at least one insulating layer 12 formed on the surface of the core board 11 and covering the circuit layer 111; at least one conductive circuit layer 15 formed on the insulating layer 12; and metal identifiable information 140 disposed at a non-circuit area 12a of the insulating layer 12. The non-circuit area 12a is provided with a plurality of openings for accommodating the metal identifiable information 140 therein. The metal identifiable information 140 may be located in any insulating layer intended to be formed with a circuit layer within the circuit board or located in the same layer as the outer circuit layer. In either case, the metal identifiable information 140 can be read by a suitable test instrument or method.

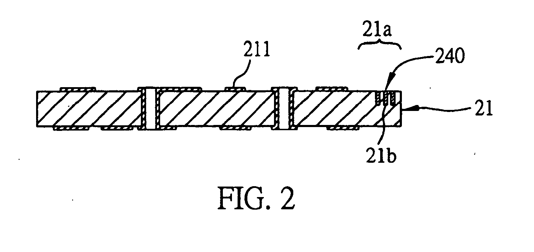

Referring to FIG. 2, besides the conductive layers of the above circuit board, metal identifiable information 240 can also be formed in a core board 21, so as to achieve a double-layer circuit board with identifiable information according to another preferred embodiment of the present invention. This circuit board comprises the core board 21 on a surface thereof having a patterned circuit layer 211 and a non-circuit area 21 a not having the circuit layout, wherein the non-circuit area 21 a is provided with a plurality of openings 21b; and the metal identifiable information 240 disposed in the plurality of openings 21 b of the non-circuit area 21a.

In this embodiment, the circuit board may further include at least one insulating layer formed on the surface of the core board and at least one conductive circuit layer formed on the insulating layer, thereby not limited to the double-layer circuit board.

Therefore, the circuit board with identifiable information and the method for fabricating the same according to the present invention are to form a plurality of openings 21 b in a non-circuit area 21a of the circuit board 21 not having a circuit layout during fabrication of the circuit board. The openings may be shaped as letters or patterns, allowing a metal layer to be deposited in the openings during the fabrication of the circuit board. The letters or patterns formed by the metal layer in the openings are used as metal identifiable information for identifying and tracing the circuit board from the fabricating processes to a status of being in use, thereby providing a reliable product tracing mechanism. Moreover, the metal identifiable information of the circuit board can be formed in any insulating layer intended to be formed with a circuit layer within a multi-layer circuit board so as not to occupy the outer circuit layout space. In such a case, when the circuit board is fabricated, the metal identifiable information is readable using an X-ray instrument instead of by eyes or a microscope. Alternatively, in the case of having sufficient outer circuit layout space on the circuit board, the metal identifiable information may be formed in same layer as the outer circuit layer and thus can be directly identified by eyes, a microscope or a bar code reader.

The invention has been described using exemplary preferred embodiments. However, it is to be understood that the scope of the invention is not limited to the disclosed embodiments. On the contrary, it is intended to cover various modifications and similar arrangements. The scope of the claims, therefore, should be accorded the broadest interpretation so as to encompass all such modifications and similar arrangements.

## Claims

1. A method for fabricating a circuit board with metal identifiable information marks (140), comprising the steps of:
preparing a core board (11) having a patterned circuit layer (111) formed thereon;
forming an insulating layer (12) on the core board (11);
forming a plurality of first openings (13) and second openings (14) in the insulating layer (12), wherein the first openings (13) are disposed on a part of the patterned circuit layer (111), and the second openings (14) are located at a non-circuit area of the insulating layer (12) free of a circuit layout, wherein the second openings (14) do not penetrate the insulating layer (12);
performing a circuit build-up process to form a conductive circuit layer (15) on the insulating layer (12), a plurality of conductive vias (130) in the first openings (13), and metal identifiable information marks (140) in the second openings (14), wherein the metal identifiable information marks (140) are formed by electroplating and not electrically conductive to the conductive circuit layer (15); and
forming a patterned insulating protection layer (16) to cover an outer conductive circuit layer (15) and the non-circuit area of an outer insulating layer (12).

2. The method of claim 1, wherein the first openings (13) and the second openings (14) are formed by laser drilling technology.

3. The method of claim 1, wherein the metal identifiable information marks (140) in the second openings (14) are one selected from the group consisting of numbers, letters, bar codes, and patterns.

4. The method of claim 1, further comprising continuously providing an insulating layer (12) on the surface of the circuit board and performing the circuit build-up process to form another conductive circuit layer (15) on the circuit board before forming the patterned insulating protection layer (16).

5. The method of claim 1, wherein the metal identifiable information marks (140) are formed in an insulating layer intended to be formed with a circuit layer within the circuit board.

6. The method of claim 5, wherein the metal identifiable information marks (140) are recognizable using X-ray.

7. The method of claim 1, wherein the metal identifiable information marks (140) are located in the same layer (12) as an outer circuit layer of the circuit board.

8. The method of claim 7, wherein the metal identifiable information marks (140) are readable by one selected from the group consisting of the naked eye, a microscope, and a bar code reader.

9. A circuit board with metal identifiable information marks (140), comprising:
a circuit board having at least one internal insulating layer (12) with a non-circuit area free of a circuit layout;
a plurality of openings (14) disposed in the non-circuit area of the insulating layer (12), wherein the openings do not penetrate the insulating layer (12);
a conductive circuit layer (15) disposed on a surface of the insulating layer (12);
metal identifiable information marks (140) electroplated into the openings (14) of the non-circuit area, wherein the electroplated metal identifiable information marks (140) are not electrically conductive to the conductive circuit layer (15); and
a patterned insulating protection layer (16) disposed on the circuit board for covering an outer conductive circuit layer (15) and the non-circuit area of an outer insulating layer (12).

10. The circuit board of claim 9, wherein the metal identifiable information marks (140) electroplated into the openings (14) are one selected from the group consisting of numbers, letters, bar codes, and patterns.

11. The circuit board of claim 9, wherein the metal identifiable information marks (140) electroplated are formed in one of an insulating layer of a core board and a build-up circuit layer.

## Patentansprüche

1. Verfahren zum Herstellen einer Leiterplatte mit identifizierbaren metallischen Informationsmarkierungen (140), das die Schritte umfasst, dass:
eine Kernplatte (11), auf der eine strukturierte Schaltkreisschicht (111) ausgebildet ist, angefertigt wird;
eine Isolierschicht (12) auf der Kernplatte (11) gebildet wird;
mehrere erste Öffnungen (13) und zweite Öffnungen (14) in der Isolierschicht (12) gebildet werden, wobei die ersten Öffnungen (13) auf einem Teil der strukturierten Schaltkreisschicht (111) angeordnet sind und die zweiten Öffnungen (14) sich in einem Nicht-Schaltkreis-Bereich der Isolierschicht (12) befinden, welcher frei von einer Schaltkreisanordnung ist, wobei die zweiten Öffnungen (14) die Isolierschicht (12) nicht durchdringen;
ein Schaltkreisaufbauprozess durchgeführt wird, um eine leitende Schaltkreisschicht (15) auf der Isolierschicht (12), mehrere leitende Durchkontaktierungen (130) in den ersten Öffnungen (13) und identifizierbare metallische Informationsmarkierungen (140) in den zweiten Öffnungen (14) zu bilden, wobei die identifizierbaren metallischen Informationsmarkierungen (140) durch Galvanisieren gebildet werden und nicht elektrisch leitend zu der leitenden Schaltkreisschicht (15) sind; und
eine strukturierte Isolierschutzschicht (16) gebildet wird, um eine äußere leitende Schaltkreisschicht (15) und den Nicht-Schaltkreis-Bereich einer äußeren Isolierschicht (12) zu bedecken.

2. Verfahren nach Anspruch 1,
wobei die ersten Öffnungen (13) und die zweiten Öffnungen (14) durch eine Laserbohrtechnologie gebildet werden.

3. Verfahren nach Anspruch 1,
wobei die identifizierbaren metallischen Informationsmarkierungen (140) in den zweiten Öffnungen (14) aus der Gruppe ausgewählt sind, die aus Zahlen, Buchstaben, Barcodes und Mustern besteht.

4. Verfahren nach Anspruch 1,
das ferner umfasst, dass eine Isolierschicht (12) kontinuierlich an der Oberfläche der Leiterplatte vorgesehen wird und der Schaltkreisaufbauprozess durchgeführt wird, um eine weitere leitende Schaltkreisschicht (15) auf der Leiterplatte zu bilden, bevor die strukturierte Isolierschutzschicht (16) gebildet wird.

5. Verfahren nach Anspruch 1,
wobei die identifizierbaren metallischen Informationsmarkierungen (140) in einer Isolierschicht gebildet werden, die dazu gedacht ist, mit einer Schaltkreisschicht in der Leiterplatte gebildet zu werden.

6. Verfahren nach Anspruch 5,
wobei die identifizierbaren metallischen Informationsmarkierungen (140) unter Verwendung von Röntgenstrahlen erkennbar sind.

7. Verfahren nach Anspruch 1,
wobei die identifizierbaren metallischen Informationsmarkierungen (140) sich in der gleichen Schicht (12) wie eine äußere Schaltkreisschicht der Leiterplatte befinden.

8. Verfahren nach Anspruch 7,
wobei die identifizierbaren metallischen Informationsmarkierungen (140) durch ein Element aus der Gruppe, die aus dem bloßen Auge, einem Mikroskop und einem Barcode-Leser besteht, lesbar sind.

9. Leiterplatte mit identifizierbaren metallischen Informationsmarkierungen (140), die umfasst:
eine Leiterplatte, die mindestens eine innere Isolierschicht (12) mit einem Nicht-Schaltkreis-Bereich aufweist, welcher frei von einer Schaltkreisanordnung ist;
mehrere Öffnungen (14), die in dem Nicht-Schaltkreis-Bereich der Isolierschicht (12) angeordnet sind, wobei die Öffnungen die Isolierschicht (12) nicht durchdringen;
eine leitende Schaltkreisschicht (15), die auf einer Oberfläche der Isolierschicht (12) angeordnet ist;
identifizierbare metallische Informationsmarkierungen (140), welche in die Öffnungen (14) des Nicht-Schaltkreis-Bereichs galvanisiert sind, wobei die galvanisierten identifizierbaren metallischen Informationsmarkierungen (140) nicht elektrisch leitend zu der leitenden Schaltkreisschicht (15) sind; und
eine strukturierte Isolierschutzschicht (16), die auf der Leiterplatte angeordnet ist, um eine äußere leitende Schaltkreisschicht (15) und den Nicht-Schaltkreis-Bereich einer äußeren Isolierschicht (12) zu bedecken.

10. Leiterplatte nach Anspruch 9,
wobei die in die Öffnungen (14) galvanisierten identifizierbaren metallischen Informationsmarkierungen (140) aus der Gruppe ausgewählt sind, die aus Zahlen, Buchstaben, Barcodes und Mustern besteht.

11. Leiterplatte nach Anspruch 9,
wobei die galvanisierten identifizierbaren metallischen Informationsmarkierungen (140) in einer Isolierschicht einer Kernplatte oder einer Aufbauschaltkreisschicht gebildet sind.

## Revendications

1. Procédé pour fabriquer une carte à circuit avec des marques d'information identifiables en métal (140), comprenant les étapes consistant à :
préparer une carte d'âme (11) ayant une couche à circuits en motifs (111) formée sur elle-même ;
former une couche isolante (12) sur la carte d'âme (11) ;
former une pluralité de premières ouvertures (13) et de secondes ouvertures (14) dans la couche isolante (12), lesdites premières ouvertures (13) étant disposées sur une partie de la couche à circuits en motifs (111), et lesdites secondes ouvertures (14) étant situées dans une zone dépourvue de circuit de la couche isolante (12) exempte de motifs en circuits, lesdites secondes ouvertures (14) ne pénétrant pas dans la couche isolante (12) ;
exécuter un processus de réalisation de circuits pour former une couche à circuits conducteurs (15) sur la couche isolante (12), une pluralité de puits conducteurs (130) dans les premières ouvertures (13), et des marques d'information identifiables en métal (140) dans les secondes ouvertures (14), lesdites de marques d'informations identifiables en métal (140) étant formées par électroplacage et sans être électroconductrices sur la couche à circuits conducteurs (15) ; et
former une couche de protection d'isolation à motifs (16) pour couvrir une couche de circuits conducteurs extérieure (15) et la zone dépourvue de circuits d'une couche isolante extérieure (12).

2. Procédé selon la revendication 1, dans lequel les premières ouvertures (13) et les secondes ouvertures (14) sont formées par une technologie de perçage au laser.

3. Procédé selon la revendication 1, dans lequel les marques d'information identifiables en métal (140) dans les secondes ouvertures (14) sont choisies parmi le groupe comprenant des numéros, des lettres, des codes à barres, et des motifs.

4. Procédé selon la revendication 1, comprenant en outre de prévoir en continu une couche isolante (12) sur la surface de la carte à circuits et d'exécuter le processus de réalisation de circuits pour former une autre couche à circuits conducteurs (15) sur la carte à circuits avant de former la couche de protection isolante à motifs (16).

5. Procédé selon la revendication 1, dans lequel les marques d'informations identifiables en métal (140) sont formées dans une couche isolante destinée à être formée avec une couche à circuits dans la carte à circuits.

6. Procédé selon la revendication 5, dans lequel les marques d'informations identifiables en métal (140) sont reconnaissables en utilisant des rayons X.

7. Procédé selon la revendication 1, dans lequel les marques d'informations identifiables en métal (140) sont situées dans la même couche (12) qu'une couche à circuits extérieure de la carte à circuits.

8. Procédé selon la revendication 7, dans lequel les marques d'informations identifiables en métal (140) sont lisibles par un organe choisi parmi le groupe comprenant l'oeil nu, un microscope, et un lecteur de codes à barres.

9. Carte à circuits avec des marques d'information identifiables en métal (140), comprenant :
une carte à circuits ayant au moins une couche d'isolation interne (12) avec une zone exempte de circuits dépourvue de motifs en circuits ;
une pluralité d'ouvertures (14) disposées dans la zone dépourvue de circuits de la couche isolante (12), lesdites ouvertures ne pénétrant pas dans la couche isolante (12) ;
une couche à circuits conducteurs (15) disposée sur une surface de la couche isolante (12) ;
des marques d'information identifiables en métal (140) déposé par électroplacage dans les ouvertures (14) de la zone dépourvue de circuits, lesdites marques d'informations identifiables en métal déposées par électroplacage (140) n'étant pas électriquement conductrices vers la couche à circuits conducteurs (15); et
une couche de protection isolante à motifs (16) disposée sur la carte à circuits pour couvrir une couche à circuits conducteurs extérieure (15) et la zone dépourvue de circuits d'une couche isolante extérieure (12).

10. Carte à circuits selon la revendication 9, dans laquelle les marques d'informations identifiables en métal (140) déposées par électroplacage dans les ouvertures (14) sont des marques choisies parmi le groupe comprenant des numéros, des lettres, des codes à barres, et des motifs.

11. Carte à circuits selon la revendication 9, dans laquelle les marques d'informations identifiables en métal (140) déposées par électroplacage sont formées soit dans une couche isolante d'une carte d'âme soit dans une couche à circuits déposée.
